# EUROPEAN PATENT APPLICATION

(11) **EP 4 207 576 A1**
(43) Date of publication of application: **05.07.2023**
(21) Application number: 21861573.0
(22) Date of filing: 24.08.2021
(51) Int. Cl.: H02N 2/18

(54) **VIBRATION POWER GENERATION DEVICE AND SENSOR MODULE**

(30) Priority: 25.08.2020 JP 2020142105
(71) Applicant: Kyocera Corporation, Kyoto-shi Kyoto 612-8501 (JP)
(72) Inventor: KITAYAMA, Satoshi, Kyoto-shi, Kyoto 612-8501 (JP); OOKUBO, Tomoaki, Kyoto-shi, Kyoto 612-8501 (JP)
(74) Representative: TBK
(86) International application number: PCT/JP2021/031034
(87) International publication number: WO 2022/045149

(57) **Abstract**

A vibration power generation device includes a beam including a flat surface, a piezoelectric member disposed on the flat surface of the beam, and a fixation member. The fixation member sandwiches the beam at two or more end portions of the beam from a side of a first surface of the beam and from a side of a second surface of the beam, the second surface being opposite to the first surface. At at least one of the end portions of the beam, a position of a boundary on the first surface between a contact region of the first surface in contact with the fixation member and a non-contact region of the first surface is different from a position of a boundary on the second surface between a contact region of the second surface in contact with the fixation member and a non-contact region of the second surface.

## Description

### CROSS-REFERENCE TO RELATED APPLICATIONS

This application claims the benefit of Japanese Patent Application No. 2020-142105 filed August 25, 2020, which is hereby incorporated by reference herein in its entirety.

### TECHNICAL FIELD

The present disclosure relates to a vibration power generation device and to a sensor module.

### BACKGROUND OF INVENTION

As the Internet of Things (IoT) technology becomes popular, sensor modules that detect various states of things and transmit the detection results to an external device are expected to expand the application area. Studies are conducted on obtaining energy from the ambient environment and generating the electric power for actuating the sensor module. For example, Patent Literature 1 proposes a power generation element that receives external forces from ambient environment and thereby vibrates a piezoelectric element to generate electricity.

### CITATION LIST

### PATENT LITERATURE

Patent Literature 1: International Publication No. 2019-021400

### SUMMARY

According to a first aspect of the present disclosure, a vibration power generation device includes a beam including a flat surface, a piezoelectric member disposed on the flat surface of the beam, and a fixation member. The fixation member sandwiches the beam at two or more end portions of the beam from a side of a first surface of the beam and from a side of a second surface of the beam, the second surface being opposite to the first surface. At at least one of the end portions of the beam, a position of a boundary on the first surface between a contact region of the first surface in contact with the fixation member and a non-contact region of the first surface not in contact with the fixation member is different from a position of a boundary on the second surface between a contact region of the second surface in contact with the fixation member and a non-contact region of the second surface not in contact with the fixation member.

According to a second aspect of the present disclosure, a sensor module includes a vibration power generation device, a sensor, a communication unit, and a controller. The vibration power generation device includes a beam including a flat surface, a piezoelectric member disposed on the flat surface of the beam, and a fixation member. The fixation member sandwiches the beam at two or more end portions of the beam from a side of a first surface of the beam and from a side of a second surface of the beam, the second surface being opposite to the first surface. At at least one of the end portions of the beam, a position of a boundary on the first surface between a contact region of the first surface in contact with the fixation member and a non-contact region of the first surface not in contact with the fixation member is different from a position of a boundary on the second surface between a contact region of the second surface in contact with the fixation member and a non-contact region of the second surface not in contact with the fixation member. The sensor is actuated by electric power supplied from the vibration power generation device. The communication unit is actuated by the electric power supplied from the vibration power generation device and is configured to communicate with an external device. The controller is actuated by the electric power supplied from the vibration power generation device and is configured to control the sensor and the communication unit.

### BRIEF DESCRIPTION OF THE DRAWINGS

FIG. 1 is a functional block diagram illustrating a schematic structure of a sensor module that includes a vibration power generation device according to an embodiment.
FIG. 2 is a cross-sectional view illustrating the vibration power generation device of the embodiment, which is cut in a vibration direction of the vibration power generation device.
FIG. 3 is a top view illustrating the vibration power generation device of FIG. 2 when the vibration power generation device is viewed in the vibration direction and an upper housing is removed.
FIG. 4 is an enlarged view illustrating a piezoelectric member of FIG. 2.
FIG. 5 is an enlarged view of a boundary region of FIG. 2.
FIG. 6 is a graph for explanation of a difference in frequency characteristics between a vibration power generation device equipped with a known fixation member and the vibration power generation device equipped with a fixation member of the present disclosure.
FIG. 7 is an enlarged view of the boundary region of FIG. 2, illustrating a modification example.
FIG. 8 is a cross-sectional view illustrating a modification example of the vibration power generation device of FIG. 2, which is cut in the vibration direction.
FIG. 9 is a top view illustrating another modification example of the vibration power generation device of FIG. 2 when the vibration power generation device is viewed in the vibration direction and the upper housing is removed.

### DESCRIPTION OF EMBODIMENT

An embodiment of the present disclosure is described with reference to the drawings. The drawings to which the following description refers are schematic illustrations. Dimensional relationships of elements in the drawings do not necessarily correspond to actual ones.

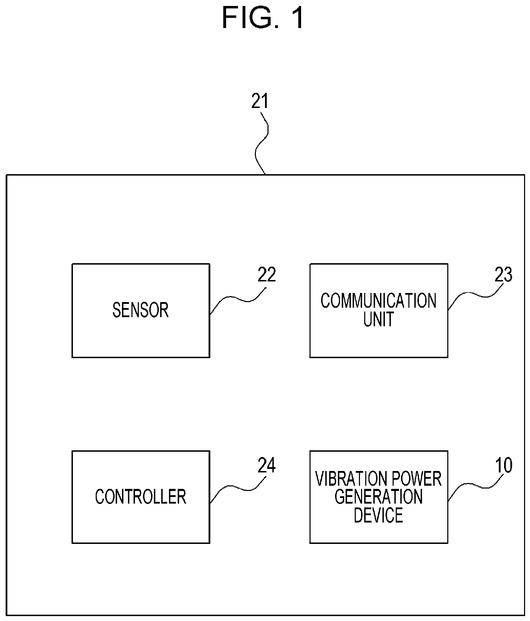

As illustrated in FIG. 1, a vibration power generation device 10 according to the embodiment of the present disclosure is disposed in a sensor module 21. The sensor module 21 includes a sensor 22, a communication unit 23, a controller 24, and the vibration power generation device 10. The sensor module 21 is configured to detect various states of things and transmit the detection results to an external device without receiving electric power from outside. The sensor module 21 is applied to, for example, a bridge, a railroad car, and a factory machine.

The sensor 22 is configured to detect an arbitrary state of an arbitrary object. Examples of the sensor 22 are a vibration sensor, a temperature sensor, and a pressure sensor. The sensor 22 is actuated by the electric power supplied from the vibration power generation device 10.

The communication unit 23 includes a communication module for communication with an external device through a network. For example, the sensor 22 detects an arbitrary state of a thing, and the communication unit 23 transmits a signal containing detection results to the external device. The communication unit 23 may receive instructions from the external device and transmit the instructions to the controller 24. The communication unit 23 is actuated by the electric power supplied from the vibration power generation device 10.

The controller 24 includes one or more processors and a memory. The processor may be a general purpose processor that performs a specific function in accordance with a specific program provided or may be a special purpose processor dedicated to a specific function. The special purpose processor may include an application specific integrated circuit (ASIC). The above processor may include a programmable logic device (PLD). The PLD may further include a field-programmable gate array (FPGA). The controller 24 may be either a system in a package (SiP) or a system on a chip (SoC) with which one or more processors collaborate. The controller 24 controls the sensor 22 and the communication unit 23. The controller 24 is actuated by the electric power supplied from the vibration power generation device 10.

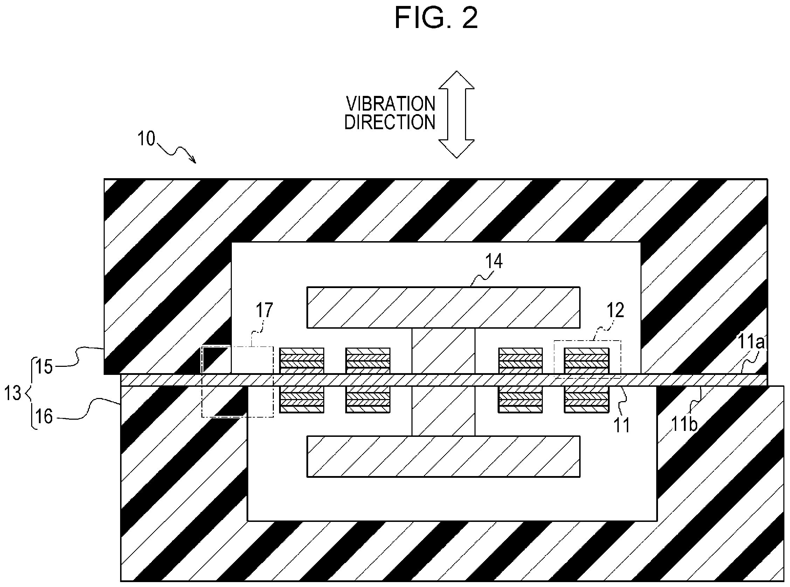

As illustrated in FIG. 2, the vibration power generation device 10 includes a beam 11, piezoelectric members 12, and a housing 13. The housing 13 is a fixation member. The vibration power generation device 10 may also include a weight 14. The beam 11 and the weight 14 are included in a vibration portion that vibrates in response to vibrations from the ambient environment.

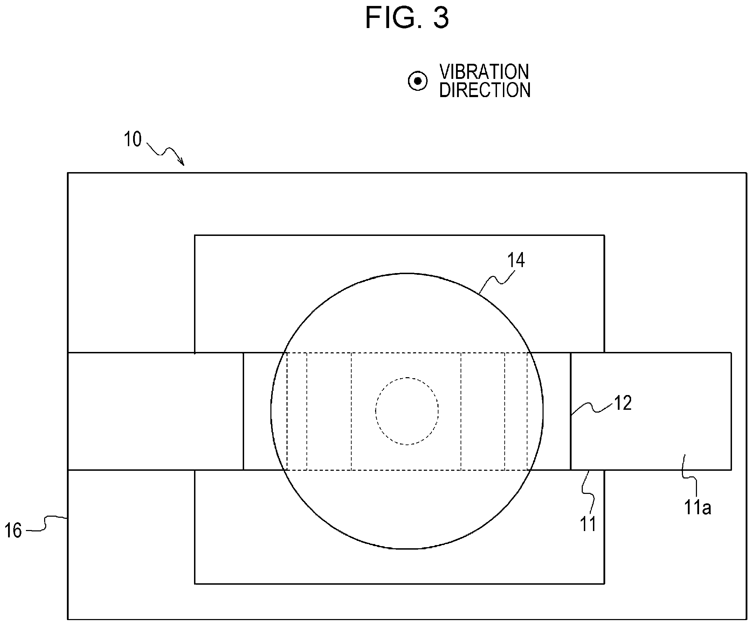

The beam 11 has flat surfaces. The beam 11 is a tabular member made of, for example, a stainless steel (SUS) and having elasticity. The beam 11 can have multiple end portions. In the case of the weight 14 being provided, the weight 14 may be disposed at the center of the beam 11. The beam 11 may extend from the weight 14 in different directions. In the present embodiment, as illustrated in FIG. 3, the beam 11 has a rectangular shape elongated in one direction as viewed in plan. In the present embodiment, the beam 11 has end portions at opposite ends of the beam 11 in the extending direction thereof.

The housing 13 fixes the end portions of the beam 11 that are positioned oppositely in the extending direction of the beam 11. In other words, the housing 13 supports the opposite ends of the beam 11. The vibration power generation device 10 receives vibrations from the ambient environment, which causes the beam 11 to vibrate in the direction normal to the surfaces of the beam 11. The vibration direction of the beam 11 is indicated in FIGs. 2 and 3.

The weight 14 provides inertia to the beam 11 and thereby intensifies the vibration of the beam 11 that is supported by the housing 13. The weight 14 may be disposed at a surface of the beam 11, the surface facing in the vibration direction in which the beam 11 vibrates. The weight 14 may be disposed at opposite surfaces of the beam 11, the surfaces facing in the vibration direction. The weight 14 does not need to be a member different from the beam 11. In other words, the weight 14 may be formed integrally with the beam 11.

The piezoelectric member 12 is disposed at a position at which stress occurs to the piezoelectric member 12 due to the vibration of the beam 11. The piezoelectric member 12 is disposed on the flat surface of the beam 11. The piezoelectric member 12 may be disposed on the surface of the beam 11 that faces in the vibration direction. Multiple piezoelectric members 12 may be arranged side by side on the beam 11 in the extending direction thereof. Multiple piezoelectric members 12 may be disposed on the opposite surfaces of the beam 11 that face in the vibration direction. Note that in FIGs. 2 and 3, a reference sign is only given to one of the piezoelectric members 12.

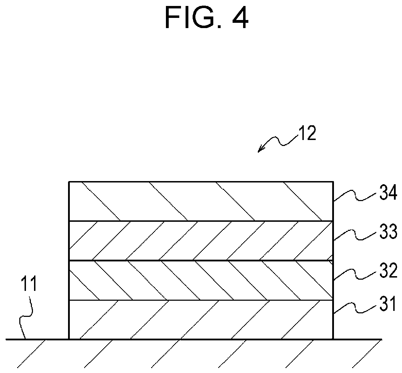

As illustrated in FIG. 4, the piezoelectric member 12 includes an insulating film 31, a lower electrode 32, a piezoelectric film 33, an upper electrode 34, which are laminated in this order from the beam 11. The deformation of the beam 11 due to vibration deforms the insulating film 31, the lower electrode 32, the piezoelectric film 33, and the upper electrode 34. Accordingly, when the beam 11 vibrates, the piezoelectric film 33 is subjected to stress, and the stress is converted into electric power due to the piezoelectric effect of the piezoelectric film 33. The electric power generated in the piezoelectric film 33 is output to a device outside the vibration power generation device 10 via the lower electrode 32 and the upper electrode 34.

The housing 13 sandwiches the opposite end portions of the beam 11 from the side of a first surface 11a of the beam 11 and from the side of a second surface 11b of the beam 11, the first surface 11a being opposite to the second surface 11b. For example, the first surface 11a is the upper surface of the beam 11 as illustrated in FIG. 2. For example, the second surface 11b is the lower surface of the beam 11 as illustrated in FIG. 2. For example, the housing 13 may include an upper housing 15 positioned at the side of the first surface 11a of the beam 11 and a lower housing 16 positioned at the side of the second surface 11b of the beam 11. The upper housing 15 is a first fixation member, and the lower housing 16 is a second fixation member. A recess may be formed in one or both of the upper housing 15 and the lower housing 16 at the position where the beam 11 is sandwiched. The recess is provided to accommodate part of the beam 11.

In the present embodiment, as illustrated in FIG. 2, a contact region of the first surface 11a of the beam 11 in contact with the upper housing 15 adjoins a non-contact region of the first surface 11a at a boundary on the first surface 11a at each of the opposite end portions of the beam 11. Similarly, a contact region of the second surface 11b of the beam 11 in contact with the lower housing 16 adjoins a non-contact region of the second surface 11b at a boundary on the second surface 11b at each of the opposite end portions of the beam 11. The position of the boundary on the first surface 11a is shifted in the same direction from the position of the boundary on the second surface 11b at each of the opposite end portions of the beam 11. For example, the upper housing 15 and the lower housing 16 are shaped such that the inside surfaces of respective upper and lower housings 15 and 16 can be flush with each other with the beam 11 being interposed therebetween. The upper housing 15 and the lower housing 16 shaped as such are shifted from each other in the extending direction of the beam 11 when the upper housing 15 and the lower housing 16 are joined together.

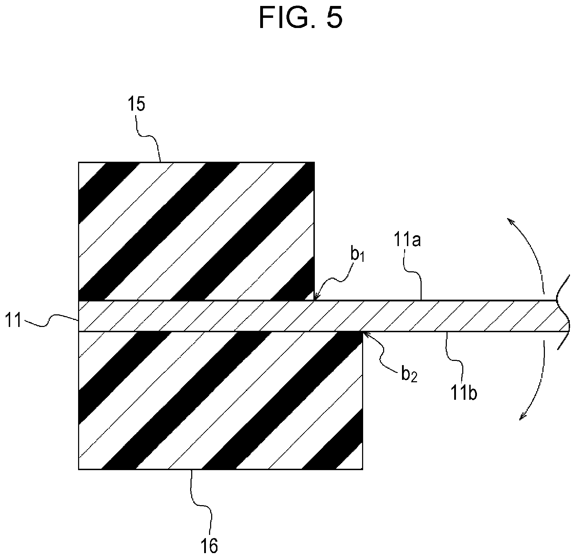

As illustrated in FIG. 5, a boundary b1 refers to the boundary between the contact region of the first surface 11a of the beam 11 in contact with the upper housing 15 and the non-contact region of the first surface 11a, and a boundary b2 refers to the boundary between the contact region of the second surface 11b of the beam 11 in contact with the lower housing 16 and the non-contact region of the second surface 11b. As illustrated in FIG. 5, the position of the boundary b1 is different in the extending direction of the beam 11 from the position of the boundary b2. The boundary b1 extends on the first surface 11a in a direction orthogonal to the extending direction of the beam 11. Similarly, the boundary b2 extends on the second surface 1b in a direction orthogonal to the extending direction of the beam 11. When the beam 11 bends toward the side of the first surface 11a during vibration, the boundary b1 serves as the fulcrum of vibration of the beam 11. On the other hand, when the beam 11 bends toward the side of the second surface 11b during vibration, the boundary b2 serves as the fulcrum of vibration of the beam 11.

Accordingly, in the vibration power generation device 10 of the present embodiment, the fulcrum of vibration is shifted regularly in each period of vibration of the beam 11. When the fulcrum of vibration is shifted in each period of vibration, the resonance frequency becomes lower and the frequency width at half maximum of the resonant peak becomes larger compared with a beam 11 that is fixed so as to have the same boundary positions in the extending direction of the beam 11. The cause of this effect may be related to attenuation of vibration due to the fulcrum of vibration being shifted.

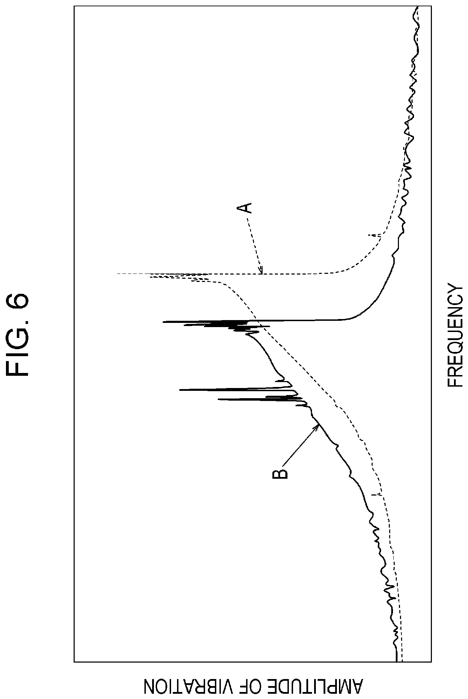

FIG. 6 contrasts two graphs, in other words, graph A and graph B. Graph A illustrates a frequency characteristics of amplitude of vibration of a beam included in a known vibration power generation device, while graph B illustrates a frequency characteristics of amplitude of vibration of the beam 11 included in the vibration power generation device 10 of the present disclosure. Graph A was resulted from the beam 11 that was sandwiched between the upper housing 15 and the lower housing 16 in such a manner that the boundary b 1 on the first surface 11a and the boundary b2 on the second surface 11b came to the same position in the extending direction of the beam 11. The beam 11 was made of a plate of a stainless steel (SUS). The effective length of the beam 11 that can vibrate was set to be 40 mm. In other words, the distance between the boundaries between the contact region and the non-contact region of the beam 11 and the housing 13 at respective end portions of the beam 11 was set to be 40 mm. On the other hand, the graph B was resulted from the same vibration power generation device 10 as used for graph A. In the case of graph B, however, the upper housing 15 and the lower housing 16 between which the beam 11 is sandwiched were shifted from each other by 1 mm in the extending direction of the beam 11. Accordingly, at each of the opposite end portions of the beam 11, the boundary b1 between the contact region and the non-contact region of the beam 11 and the upper housing 15 was shifted by 1 mm in the same direction from the boundary between the contact region and the non-contact region of the beam 11 and the lower housing 16.

As illustrated in FIG. 6, according to graph B of the frequency characteristics for the vibration power generation device 10 of the present embodiment, the resonance frequency was confirmed to become lower and the frequency width at half maximum was also confirmed to become larger compared with the graph A. In accordance with the examples illustrated by graph A and graph B, the resonance frequency decreased from 198 Hz to 191 Hz by shifting the upper housing 15 by 1 mm from the lower housing 16. The frequency width at half maximum increased from 9.4 Hz to 12.4 Hz. Decreasing the resonance frequency enables the vibration power generation device 10 to convert lower-frequency vibrations of the ambient environment into electric power. In addition, widening the resonance frequency enables the vibration power generation device 10 to generate electric power in a wider-frequency range of vibrations of the ambient environment. As a result, the vibration power generation device 10 of the present disclosure can increase the amount of electricity.

In the example illustrated in FIG. 5, the upper housing 15 and the lower housing 16 include substantially right-angled corner portions at the boundaries b1 and b2, and the right-angled corner portions are in contact with respective surfaces of the beam 11. Accordingly, the fulcrum of vibration is shifted instantly in response to the change from the state of the beam 11 bending toward the side of the first surface 11a to the state of the beam 11 bending toward the side of the second surface 11b. In other words, the fulcrum of vibration shifts intermittently during the vibration of the beam 11. This enhances the effect obtained by decreasing the resonance frequency and by widening the range of resonance frequency.

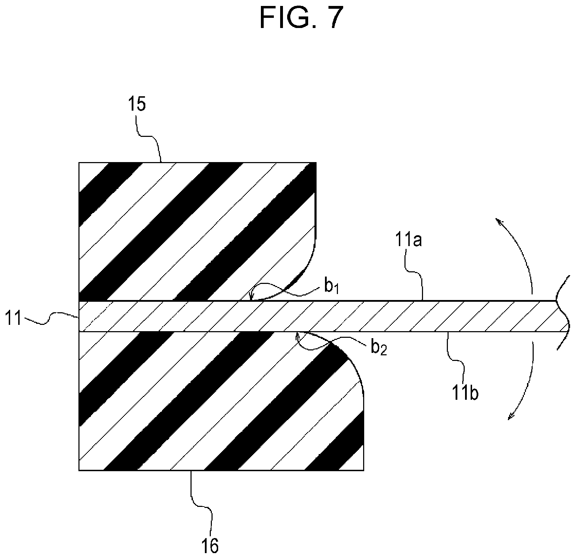

The upper housing 15 and the lower housing 16 may include respective rounded corner portions that adjoin the beam 11 in the boundary region as illustrated in FIG. 7, which contrasts the boundary region of FIG. 5. In this case, both boundaries between the contact region and the non-contact region of the beam 11 in contact with respective upper and lower housings 15 and 16 can change in position so as to follow the amplitude of bending of the beam 11 during vibration. Accordingly, the position of the fulcrum of vibration changes continuously during vibration of the beam 11. The continuous change of the fulcrum position can reduce the risk of the vibration power generation device 10 breaking.

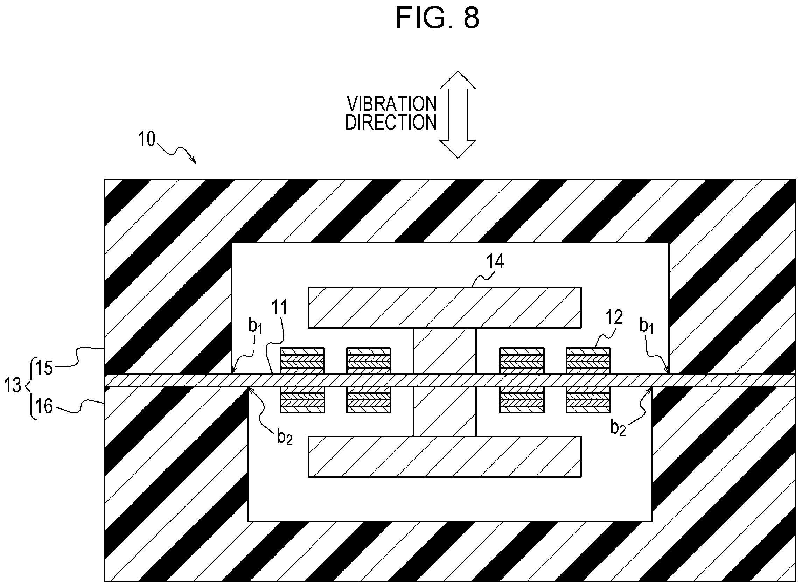

In the above embodiment described with reference to FIGs. 2 to 7, at the opposite end portions of the beam 11, the position of the boundary b1 between the contact region and the non-contact region of the first surface 11a and the upper housing 15 is shifted in the same direction from the position of the boundary b2 between the contact region and the non-contact region of the second surface 11b and the lower housing 16. However, as illustrated in FIG. 8, at the opposite end portions of the beam 11, the position of the boundary b1 between the contact region and the non-contact region of the first surface 11a and the upper housing 15 may be shifted in the opposite directions from the position of the boundary b2 between the contact region and the non-contact region of the second surface 11b and the lower housing 16. In the vibration power generation device 10 configured as described above, the fulcrum of vibration is shifted in response to the change between the state of the beam 11 bending toward the side of the first surface 11a and the state of the beam 11 bending toward the side of the second surface 11b. Accordingly, the same advantageous effects as those of the vibration power generation device 10 described in relation to FIGs. 2 to 7 can be obtained. In addition, in the vibration power generation device 10 of FIG. 8, the effective length of the beam 11 that can vibrate changes between the state of the beam 11 bending toward the side of the first surface 11a and the state of the beam 11 bending toward the side of the second surface 11b. This can further widen the range of resonance frequency.

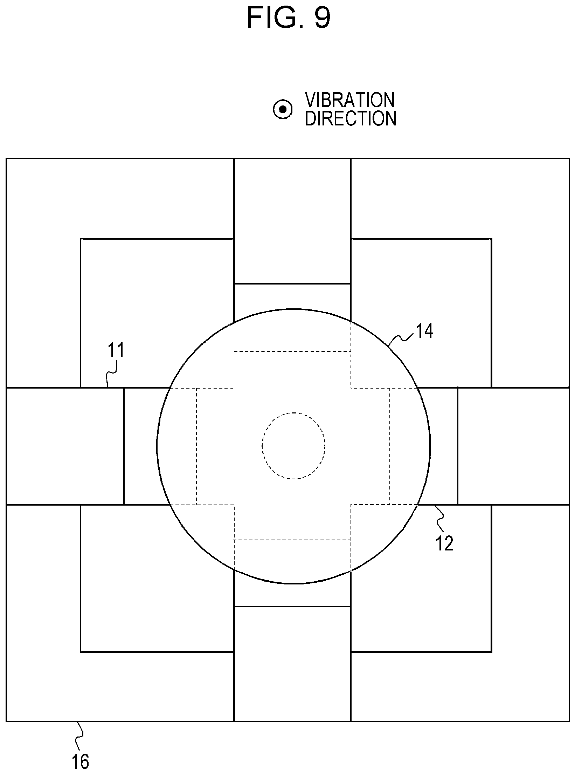

The beam of the vibration power generation device 10 is not limited to the beam 11 having the rectangular shape elongated in one direction as viewed in plan. The beam 11 may have various different shapes. For example, as illustrated in FIG. 9, the beam 11 of the vibration power generation device 10 may extend in four directions from the center of the beam 11 at which the weight 14 is disposed. In this case, the boundary on the first surface 11a between the contact region and the non-contact region of the beam 11 and the housing 13 may be different in position from the boundary on the second surface 11b between the contact region and the non-contact region of the beam 11 and the housing 13 at at least one of the four end portions of the beam 11. This configuration also provides the advantageous effects of the present disclosure.

The present invention has been described with reference to the drawings and through examples. Note that those skilled in the art can modify and/or alter the embodiment easily on the basis of the present disclosure. Accordingly, such modifications and/or alterations are deemed within the scope of the invention.

For example, in the above embodiment, the fixation member that fixes the beam 11 has been described as the housing 13 that includes the upper housing 15 and the lower housing 16. The fixation member for fixing the beam 11, however, is not limited to the housing 13 that includes the upper housing 15 and the lower housing 16. The vibration power generation device 10 may include another fixation member that is different from the housing for fixing the beam 11. The fixation member to which the beam 11 is fixed may be incorporated in the housing 13. In the case of the vibration power generation device 10 including the fixation member that is different from the housing 13, the vibration power generation device 10 does not need to include the housing 13. The vibration power generation device 10 can be incorporated in a different device, such as the sensor module 21.

The terms used in the above embodiment, including "upper" or "lower", are adopted for the purpose of explaining the above examples. These terms are not intended to limit the orientation of the vibration power generation device and of the sensor module of the present disclosure. The vibration power generation device and the sensor module of the present disclosure can be disposed so as to face in various different directions.

### REFERENCE SIGNS

- 10: vibration power generation device
- 11: beam
- 12: piezoelectric member
- 13: housing (fixation member)
- 14: weight
- 15: upper housing (first fixation member)
- 16: lower housing (second fixation member)
- 17: boundary region
- 21: sensor module
- 22: sensor
- 23: communication unit
- 24: controller
- 31: insulating film
- 32: lower electrode
- 33: piezoelectric film
- 34: upper electrode

## Claims

1. A vibration power generation device, comprising:
a beam including a flat surface;
a piezoelectric member disposed on the flat surface of the beam; and
a fixation member sandwiching the beam at two or more end portions of the beam from a side of a first surface of the beam and from a side of a second surface of the beam, the second surface being opposite to the first surface, wherein
at at least one of the end portions of the beam, a position of a boundary on the first surface between a contact region of the first surface in contact with the fixation member and a non-contact region of the first surface not in contact with the fixation member is different from a position of a boundary on the second surface between a contact region of the second surface in contact with the fixation member and a non-contact region of the second surface not in contact with the fixation member.

2. The vibration power generation device according to claim 1, wherein
the position of the boundary on the first surface is different in an extending direction of the beam from the position of the boundary on the second surface.

3. The vibration power generation device according to claim 1 or 2, wherein
the beam is made of a tabular member having elasticity.

4. The vibration power generation device according to any one of claims 1 to 3, wherein
the fixation member includes a substantially right-angled corner portion at each position of the boundary, the corner portion being in contact with the beam.

5. The vibration power generation device according to any one of claims 1 to 3, wherein
the fixation member includes a rounded corner portion at each position of the boundary, the corner portion being in contact with the beam.

6. The vibration power generation device according to any one of claims 1 to 5, wherein
the fixation member includes a first fixation member positioned at the side of the first surface of the beam and a second fixation member positioned at the side of the second surface of the beam,
the beam is sandwiched by the first fixation member and the second fixation member at opposite end portions of the beam positioned in the extending direction thereof, and
at the opposite end portions of the beam, the position of the boundary between the contact region and the non-contact region of the beam and the first fixation member is shifted in the same direction from the position of the boundary between the contact region and the non-contact region of the beam and the second fixation member.

7. The vibration power generation device according to any one of claims 1 to 5, wherein
the fixation member includes a first fixation member positioned at the side of the first surface of the beam and a second fixation member positioned at the side of the second surface of the beam,
the beam is sandwiched by the first fixation member and the second fixation member at opposite end portions of the beam in the extending direction thereof, and
at the opposite end portions of the beam, the position of the boundary between the contact region and the non-contact region of the beam and the first fixation member is shifted in the opposite directions from the position of the boundary between the contact region and the non-contact region of the beam and the second fixation member.

8. A sensor module, comprising:
the vibration power generation device according to any one of claims 1 to 7;
a sensor actuated by electric power supplied from the vibration power generation device;
a communication device actuated by the electric power supplied from the vibration power generation device and configured to communicate with an external device; and
a controller actuated by the electric power supplied from the vibration power generation device and configured to control the sensor and the communication device.

9. The sensor module according to claim 8, wherein
the sensor module is applied to a bridge, a railroad car, or a factory machine.
